(19) Europäisches Patentamt / European Patent Office / Office européen des brevets

(11) **EP 3 595 005 A1**

(12) **EUROPEAN PATENT APPLICATION**

(43) Date of publication:
**15.01.2020 Bulletin 2020/03**

(51) Int Cl.:
***H01L 23/525*** (2006.01)

(21) Application number: **19185928.9**

(22) Date of filing: **12.07.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **13.07.2018  US 201862697411 P**
**30.05.2019  US 201916427313**

(71) Applicant: **eMemory Technology Inc.**
**Hsin-Chu**
**300 (TW)**

(72) Inventors:
• **Yang, Chao-Kan**
**302 Hsinchu County (TW)**
• **Chen, Lun-Chun**
**302 Hsinchu County (TW)**

(74) Representative: **Becker Kurig Straus**
**Patentanwälte**
**Bavariastrasse 7**
**80336 München (DE)**

(54) **SEMICONDUCTOR PROCESSING METHOD FOR MANUFACTURING ANTIFUSE STRUCTURE WITH IMPROVED IMMUNITY AGAINST ERRONEOUS PROGRAMMING**

(57)      A semiconductor processing method (200, 500) is used for manufacturing an antifuse structure. The semiconductor processing method (200, 500) may include using a first mask (M1, M51) for exposing a first well region (W1) of a semiconductor substrate (110), performing a first Boron implantation operation (BI1, BI51) to implant Boron into the first well region (W1), using a second mask (M2, M52) for exposing the first well region (W1) and the second well region (W2) of the semiconductor substrate (110), and performing a second Boron implantation operation (BI2, BI52) to implant Boron into the first well region (W1) and the second well region (W2).

~200

| Use a first mask for exposing the first well region of a semiconductor substrate and covering the second well region | ~210 |

↓

| Perform a first Boron implantation operation to implant Boron into the first well region | ~220 |

↓

| Use a second mask for exposing the first well region and the second well region of the semiconductor substrate | ~230 |

↓

| Perform a second Boron implantation operation to implant Boron into the first well region and the second well region | ~240 |

FIG. 2

EP 3 595 005 A1

**Description**

Field of the Invention

The disclosure is related to a semiconductor processing method, and more particularly, a semiconductor processing method used for manufacturing an antifuse structure with improved immunity against erroneous programming.

Background of the Invention

In the field of memory cell manufacture, an antifuse structure may be used, and the antifuse structure may be formed on a well region. For example, when an antifuse structure includes a thin oxide n-type metal-oxide-semiconductor (NMOS), two highly doped n-type (often denoted as $N^+$) regions may be formed at two sides of an antifuse layer on a p-type well.
When a high voltage is applied to the antifuse layer, the antifuse layer may be unwantedly broken through by the high voltage. This may lead to an excessive leak current, and the memory cell may be erroneously programmed.
In order to avoid erroneously programming a memory cell, a solution is required to improve the immunity of an antifuse structure against an erroneous programming operation caused by disturbance of a high voltage. Moreover, a solution using additional mask(s) is not preferred for cost considerations.

Summary of the Invention

The present invention aims at providing a semiconductor processing method used for manufacturing an antifuse structure with improved immunity against erroneous programming.
This is achieved by a semiconductor processing method according to claim 1 here below. The dependent claims pertain to corresponding further developments and improvements.
As will be seen more clearly from the detained description following below, the semiconductor processing method is used for manufacturing an antifuse structure. The semiconductor processing method may include using a first mask for exposing a first well region of a semiconductor substrate; performing a first Boron implantation operation to implant Boron into the first well region; using a second mask for exposing the first well region and the second well region of the semiconductor substrate; and performing a second Boron implantation operation to implant Boron into the first well region and the second well region.

Brief Description of the Drawings

In the following, the invention is further illustrated by way of example, taking reference to the accompanying drawings. Thereof

FIG.1 illustrates a sectional view of a memory cell according to an embodiment;
FIG.2 illustrates a flowchart of a method according to an embodiment;
FIG.3 and FIG.4 illustrate a process of performing the method of FIG.2 according an embodiment;
FIG.5 illustrates a flowchart of a method according to an embodiment;
FIG.6 to FIG.8 illustrate a process of performing the method of FIG.5 according an embodiment;
FIG.9 illustrates an n-type metal-oxide-semiconductor formed on the first well region according to an embodiment;
FIG.10 illustrates a flowchart of a method used to generated the n-type metal-oxide-semiconductor of FIG.9 according to an embodiment; and
FIG.11 to FIG.14 illustrate top views of four types of memory cells according to embodiments.

Detailed Description

According to an embodiment, it may be preferred for an antifuse structure to have a higher threshold voltage (often denoted as Vt). When an antifuse structure has a higher threshold voltage, it is more difficult for a high voltage to break through an antifuse layer to cause an erroneous programming operation. Hence, a solution without increasing the number of masks may be required to adjust a threshold voltage of an antifuse structure.

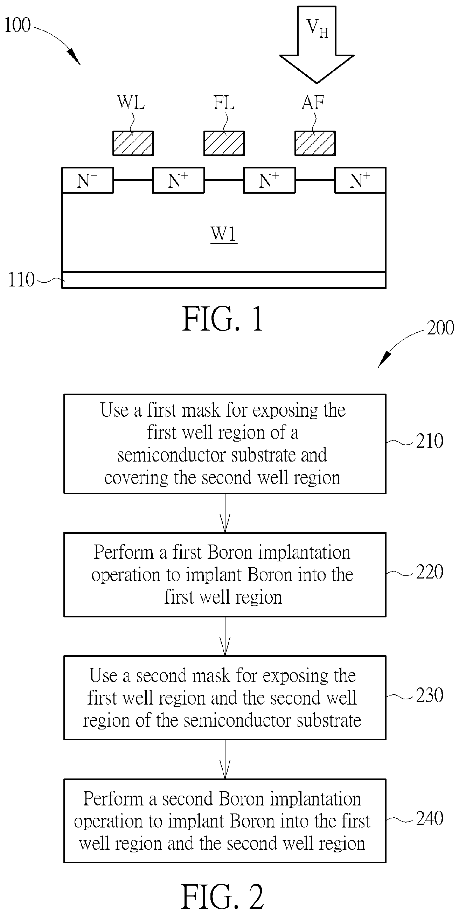

FIG.1 illustrates a sectional view of a memory cell 100 according to an embodiment. As shown in FIG.1, the memory cell 100 may be formed on a first well region W1, and the memory cell 100 may include a word line layer WL, a following line layer FL, an antifuse layer AF, and a plurality of doped regions $N^+$. The first well region W1 may be formed as a low voltage p-type well (a.k.a. LVPW), and the first well region W1 may be implanted with Boron using an LVPW setting according to an embodiment. However, when the first well region W1 is a low voltage p-type well, the threshold voltage Vt of the memory cell 100 may be so low that the antifuse layer AF may be more easily broken through by a high voltage $V_H$, and the memory cell 100 may be erroneously programed. Hence, the first well region W1 may be adjusted to heighten the threshold voltage Vt of the memory cell 100. In the condition of FIG.1, the Boron concentration of the first well region W1 may be concentration C1, and the concentration C1 may be expressed as an equation (eq-1).

$$C1 = C_{LVPW} \ldots (eq\text{-}1).$$

$C_{LVPW}$ may be Boron concentration corresponding to the low voltage p-type well (LVPW) setting.

According to an embodiment, a method for increasing the threshold voltage Vt of the memory cell 100 may include implanting Boron ions into the first well region W1. However, in order to increase the Boron concentration of the first well region W1, a plurality of Boron implantation operations may be performed, and each of the Boron implantation operations may require a dedicated mask for exposing regions needing Boron implantation and covering other regions. Hence, it is difficult to reduce the number of masks.

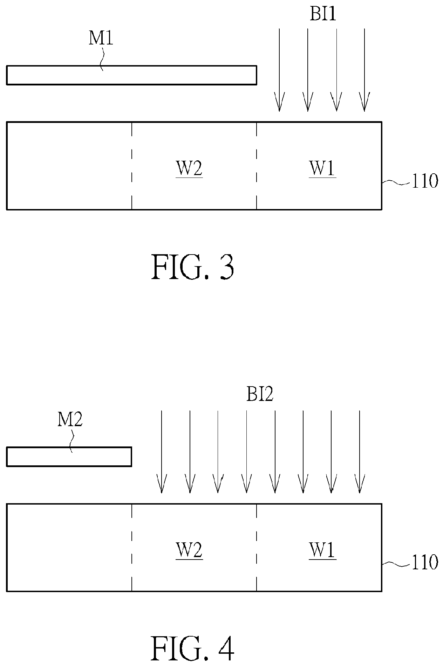

FIG.2 illustrates a flowchart of a method 200 according to an embodiment. FIG.3 and FIG.4 illustrate a process of performing the method 200 of FIG.2 according to an embodiment. The method 200 may be used for adjusting the Boron concentration of the first well region W1 without using additional mask(s). The method 200 may include the following steps.

Step 210: use a first mask M1 for exposing the first well region W1 of a semiconductor substrate 110 and covering the second well region W2;
Step 220: perform a first Boron implantation operation BI1 to implant Boron into the first well region W1;
Step 230: use a second mask M2 for exposing the first well region W1 and the second well region W2 of the semiconductor substrate 110; and
Step 240: perform a second Boron implantation operation BI2 to implant Boron into the first well region W1 and the second well region W2.

FIG.3 may be corresponding to Step 210 and Step 220 of FIG.2, and FIG.4 may be corresponding to Step 230 and Step 240 of FIG.2. As shown in FIG.2 to FIG.4, the first Boron implantation operation BI1 may be used to increase the Boron concentration of the first well region W1. The second implantation operation BI2 may be used to further increase the Boron concentration of the first well region W1 and increase the Boron concentration of the second well region W2. As shown in FIG.3 and FIG.4, the first well region W1 may be implanted with Boron twice, so the Boron concentration of the first well region W1 may be increased, a memory cell (e.g., 100) formed on the first well region W1 may have a higher threshold voltage Vt, and the memory cell may have improved immunity against incorrect program operation caused by a high voltage (e.g., $V_H$ in FIG.1) breaking through an antifuse layer.

In the example of FIG.3 to FIG.4, merely two masks (i.e., M1 and M2) and two Boron implantation operations (e.g., BI1 and BI2) may be required for adjusting the Boron concentration of the first well region W1 twice and adjusting the Boron concentration of the second well region W2 once. However, according to prior art, when intending to implant Boron to the first well region W1 twice and the second well region W2 once, at least three masks and three Boron implantation operations are required. For example, according to prior art, a first dedicated mask may be used to expose the first well region W1 to perform a first Boron implantation operation to the first well region W1, a second dedicated mask may be used to expose the second well region W2 to perform a second Boron implantation operation to the second well region W2, and a third dedicated mask may be used to expose the first well region W1 to perform a third Boron implantation operation. Hence, as compared with prior art, fewer masks and Boron implantation operations may be required to adjust the Boron concentration of the first well region W1 and the second well region W2 according to an embodiment.

According to an embodiment, in FIG.2 to FIG.4, the first well region W1 may be a low voltage (a.k.a. LV) well region, and the second well region W2 may be a middle voltage (a.k.a. MV) well region. According to another embodiment, the first well region W1 may be a low voltage well region, and the second well region W2 may be a high voltage (a.k.a. HV) well region.

According to an embodiment, in FIG.2 to FIG.4, the first Boron implantation operation BI1 may be corresponding to a low voltage p-type well (LVPW) setting, and the second Boron implantation operation BI2 may be corresponding to a high voltage p-type well (a.k.a. HVPW) setting. In this condition, the Boron concentration of the first well region W1 may be adjusted to concentration C2, where C2 may be expressed as an equation (eq-2).

$$C2 = f_2(C_{LVPW,} C_{HVPW}) \ldots (eq\text{-}2).$$

In the equation (eq-2), $f_2()$ may be a function, $C_{LVPW}$ may be as described above, and $C_{HVPW}$ may be Boron concentration corresponding to the high voltage p-type well (HVPW) setting, where the concentration C2 may be positively correlated with the concentration $C_{LVPW}$ and $C_{HVPW}$. For example, C2 may be (but not limited to) a sum of $C_{LVPW}$ and $C_{HVPW}$, that is C2 = $C_{LVPW}$ + $C_{HVPW}$. In this condition, because the first well region W1 may be implanted with Boron twice, once with the LVPW setting and once with the HVPW setting, the concentration C2 may be higher than the concentration C1.

According to another embodiment, the first Boron implantation operation BI1 may be corresponding to a low voltage p-type well (LVPW) setting, and the second Boron implantation operation BI2 may be corresponding to a high voltage p-type lightly doped drain (a.k.a. HVPLDD) setting. In this condition, the Boron concentration of the first well region W1 may be adjusted to concentration C3, where C3 may be expressed as an equation (eq-3).

$$C3 = f_3(C_{LVPW}, C_{HVPLDD}) \ldots (eq\text{-}3).$$

In the equation (eq-2), $f_3()$ may be a function, $C_{HPVLDD}$ may be Boron concentration corresponding to the high voltage p-type lightly doped drain (HVPLDD) setting, where the concentration C3 may be positively correlated with the concentration $C_{LVPW}$ and $C_{HVPLDD}$. For example, C3 may be (but not limited to) a sum of $C_{LVPW}$ and $C_{HVPLDD}$, that is C3 = $C_{LVPW}$ + $C_{HVPLDD}$. In this condition, because the first well region W1 may be implanted with Boron twice, once with the LVPW setting and once with the HVPLDD setting, the concentration C3 may be higher than the concentration C1.

According to yet another embodiment, the first Boron implantation operation BI1 may be corresponding to a low voltage p-type well (LVPW) setting, and the second Boron implantation operation BI2 may be corresponding to a medium voltage p-type well (a.k.a. MVPW) setting. In this condition, the Boron concentration of the first well region W1 may be adjusted to concentration C4, where C4 may be expressed as an equation (eq-4).

$$C4 = f_4(C_{LVPW}, C_{MVPW}) \ldots (eq\text{-}4).$$

In the equation (eq-2), $f_4()$ may be a function, and $C_{MVPW}$ may be Boron concentration corresponding to the medium voltage p-type well (MVPW) setting, where the concentration C4 may be positively correlated with the concentration $C_{LVPW}$ and $C_{MVPW}$. For example, C4 may be (but not limited to) a sum of $C_{LVPW}$ and $C_{MVPW}$, that is C4 = $C_{LVPW}$ + $C_{MVPW}$. In this condition, because the first well region W1 may be implanted with Boron twice, once with the LVPW setting and once with the MVPW setting, the concentration C4 may be higher than the concentration C1.

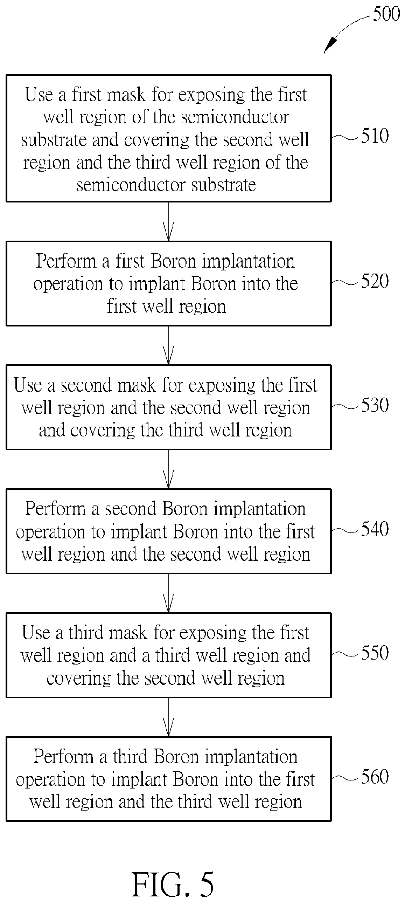

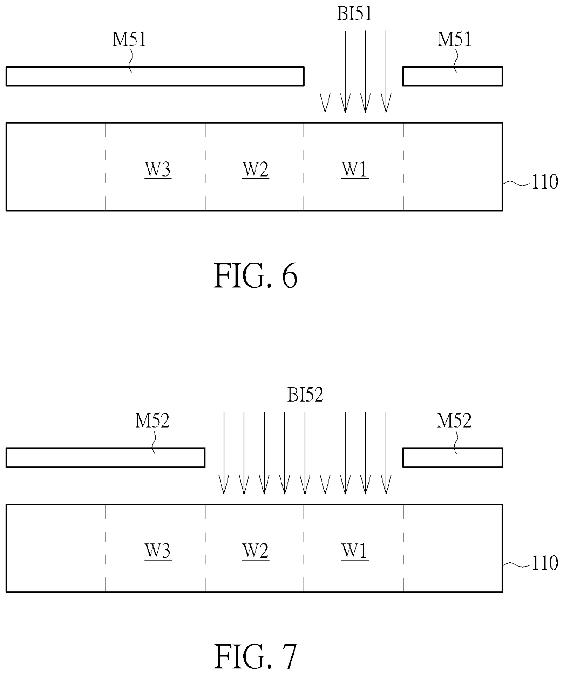

FIG.5 illustrates a flowchart of a method 500 according to an embodiment. FIG.6 to FIG.8 illustrate a process of performing the method 500 of FIG.5 according an embodiment. The method 500 may be used for adjusting the Boron concentration of the first well region W1 without using additional mask(s). The method 500 may include the following steps.

Step 510: use a first mask M51 for exposing the first well region W1 of the semiconductor substrate 110 and covering the second well region W2 and the third well region W3 of the semiconductor substrate 110;
Step 520: perform a first Boron implantation operation BI51 to implant Boron into the first well region W1;
Step 530: use a second mask M52 for exposing the first well region W1 and the second well region W2 and covering the third well region W3;
Step 540: perform a second Boron implantation operation BI52 to implant Boron into the first well region W1 and the second well region W2;
Step 550: use a third mask M53 for exposing the first well region W1 and a third well region W3 and covering the second well region W2; and
Step 560: perform a third Boron implantation operation BI53 to implant Boron into the first well region W1 and the third well region W3.

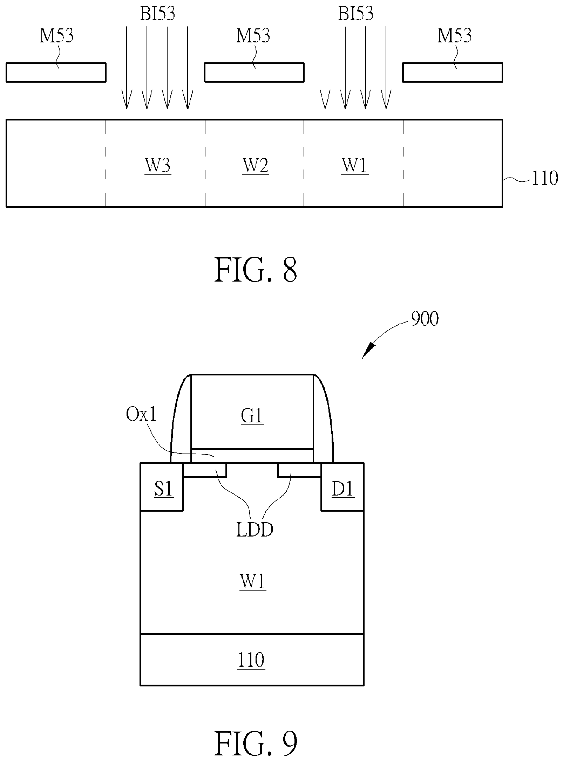

FIG.6 may be corresponding to Step 510 and Step 520 of FIG.5, FIG.7 may be corresponding to Step 530 and Step 540 of FIG.5, and FIG.8 may be corresponding to Step 550 and Step 560 of FIG.5. As shown in FIG.5 to FIG.8, the first Boron implantation operation BI51 may be used to increase the Boron concentration of the first well region W1. The second implantation operation BI52 may be used to further increase the Boron concentration of the first well region W1 and increase the Boron concentration of the second well region W2. The third implantation operation BI53 may be used to yet further increase the Boron concentration of the first well region W1 and increase the Boron concentration of the third well region W3. As shown in FIG.6 to FIG.8, the first well region W1 may be implanted with Boron three times, so the Boron concentration of the first well region W1 may be increased, a memory cell (e.g., 100) formed on the first well region W1 may have a higher threshold voltage Vt, and the memory cell may have improved immunity against incorrect program operation caused by a high voltage breaking through an antifuse layer.

In the example of FIG.6 to FIG.8, merely three masks (i.e., M51, M52 and M52) and three Boron implantation operations (e.g., BI51, BI52 and BI53) may be required for adjusting the Boron concentration of the first well region W1 three times and adjusting the Boron concentration of the second well region W2 and the third well region W3 once. However, according to prior art, when intending to implant Boron to the first well region W1 three times and implant Boron to the second well region W2 and the third well region W3 once, at least five masks and five Boron implantation operations are required. For example, according to prior art, a first dedicated mask may be used to expose the first well region W1 to perform a first Boron implantation operation to the first well region W1, a second dedicated mask may be used to expose the second well region W2 to perform a second Boron implantation operation to the second well region W2, a third dedicated mask may be used to expose the first well region W1 to perform a third Boron implantation operation, a fourth dedicated mask may be used to expose the third well region W3 to perform a fourth Boron implantation operation, and a fifth dedicated mask may be used to expose the first well region W1 to perform a fifth Boron implantation operation. Hence, as compared with prior art, fewer masks and Boron implantation operations may be required to adjust the Boron concentration of the first well region W1, the second well region W2 and the third well region W3 according to an embodiment.

According to an embodiment, in FIG.2 to FIG.4, the first well region W1 may be a low voltage (a.k.a. LV) well region, and the second well region W2 may be a middle voltage (a.k.a. MV) well region. According to another embodiment, the first well region W1 may be a low voltage well region, and the second well region W2 may be a high voltage (a.k.a. HV) well region.

According to an embodiment, in FIG.6 to FIG.8, the first well region W1 may be a low voltage (LV) well region, the second well region W2 may be a middle voltage (MV) well region, and the third well region W3 may be a high voltage (HV) well region.

According to an embodiment, the first Boron implantation operation BI51 may be corresponding to a low voltage p-type well (LVPW) setting, the second Boron implantation operation BI52 may be corresponding to a medium voltage p-type well (MVPW) setting, and the third Boron implantation operation may be corresponding to a high voltage p-type well (HVPW) setting.

In this condition, the Boron concentration of the first well region W1 may be adjusted to concentration C5, where C5 may be expressed as an equation (eq-5).

$$C5 = f_5(C_{LVPW}, C_{MVPW}, C_{HVPW}) \dots (eq\text{-}5).$$

The concentration $C_{LVPW}$, $C_{MVPW}$ and $C_{HVPW}$ may be as describe above, where the concentration C5 may be positively correlated with the concentration $C_{LVPW}$, $C_{MVPW}$ and $C_{HVPW}$. For example, C5 may be (but not limited to) a sum of $C_{LVPW}$, $C_{MVPW}$ and $C_{HVPW}$, that is $C5 = C_{LVPW} + C_{MVPW} + C_{HVPW}$. In this condition, because the first well region W1 may be implanted with Boron three times, once with the LVPW setting, once with the MVPW setting and once with the HVPW setting, the concentration C5 may be higher than the concentration C1.

Regarding FIG.2 to FIG.4 and FIG.5 to FIG.8, as described above, the Boron concentration of the first well region W1 may be adjusted to be one of the concentrations C1 to C5 by means of a set of mask(s) and a set of Boron implantation operation(s). According to embodiments, the relationship of foresaid concentrations C1 to C5 may be C1 < C2 < C3 < C4 < C5. The relationship among the threshold voltage Vt corresponding to the memory cell Vt and the abovementioned concentration C1 to C5 may be as shown in Table-1.

(Table-1)

| Condition | The threshold voltage Vt | Corresponding concentration of Boron | Corresponding set of mask and Boron implantation | Immunity against erroneous programming |
|---|---|---|---|---|
| 1 | Highest | C5 | LVPW, MVPW, HVPW | Highest |
| 2 | Second highest | C4 | LVPW, MVPW | Second highest |
| 3 | Third highest | C3 | LVPW, HVPLDD | Third highest |
| 4 | Fourth highest | C2 | LVPW, HVPW | Fourth highest |
| 5 | lowest | C1 | LVPW | lowest |

The condition 1 in Table-1 may be corresponding to FIG.5 to FIG.8. Each of the condition 2 to condition 4 in Table-1 may be corresponding to FIG.2 to FIG.4. The condition 5 may be corresponding to FIG.1 where the first well region W1 is an LVPW. As described in FIG.2 to FIG.8 and Table-1, by selecting the mask set used for performing Boron implantation operations, the immunity of a memory cell against erroneous programming may be improved without using additional masks in the manufacture process.

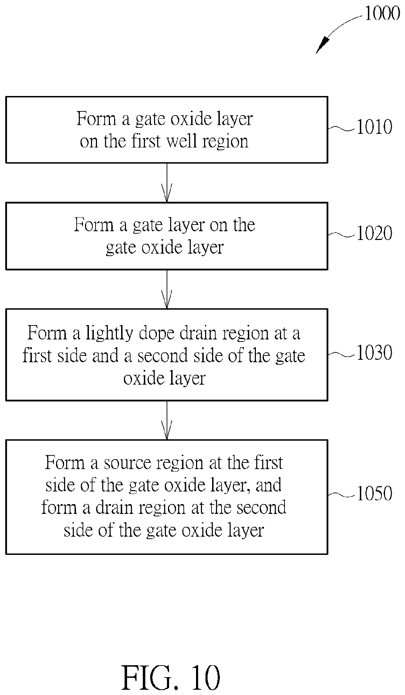

FIG.9 illustrates an n-type metal-oxide-semiconductor (NMOS) 900 formed on the first well region W1 according to an embodiment. FIG.10 illustrate a flowchart of a method 1000 used to generate the n-type metal-oxide-semiconductor 900 of FIG.9 according to an embodiment. The method 1000 may include the following steps.

Step 1010: form a gate oxide layer Ox1 on the first well region W1;
Step 1020: form a gate layer G1 on the gate oxide layer Ox1;
Step 1030: form a lightly dope drain region LDD at a first side and a second side of the gate oxide layer Ox1; and
Step 1050: form a source region S1 at the first side of the gate oxide layer Ox1, and form a drain region D1 at the second side of the gate oxide layer Ox1.

The n-type metal-oxide-semiconductor 900 may be a portion of the memory cell 100 of FIG.1 according to an embodiment. Because the n-type metal-oxide-semiconductor 900 may be formed on the first well region W1, and the threshold voltage of the first well region W1 may be increased by means of the method 200 and/or the method 500 described above, the immunity of the memory cell 1 00 against erroneous programming may be improved without using additional masks in the manufacturing process. According to an embodiment, the Step 1030 may be optionally performed since the lightly dope drain region LDD may be omitted in some applications.

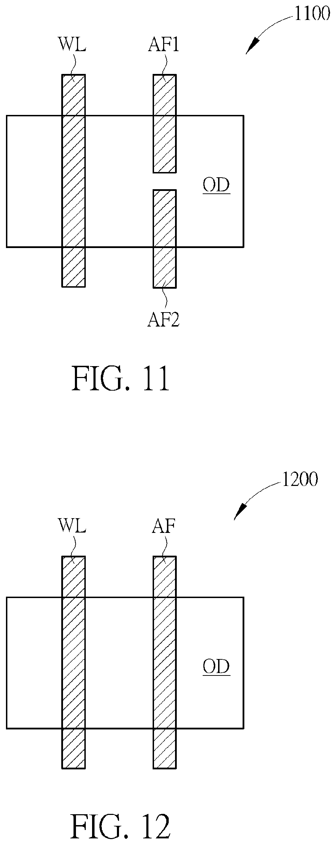

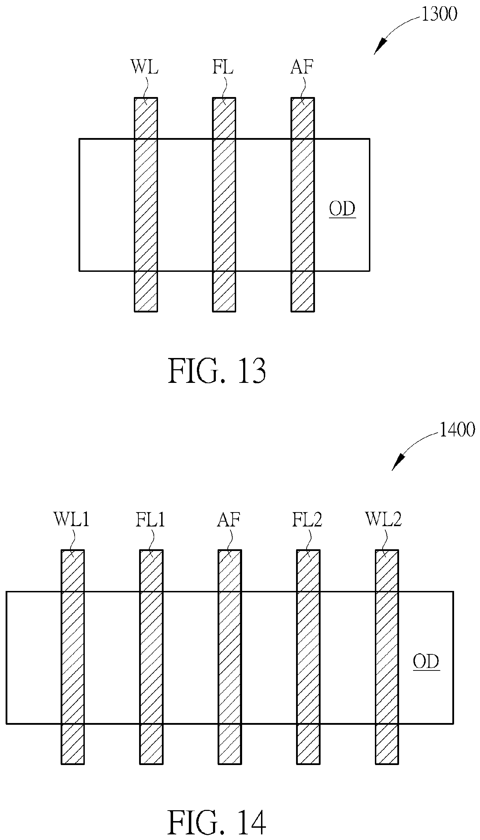

FIG.11 to FIG.14 illustrate top views of four types of memory cells according to embodiments. By means of the method 200 corresponding to FIG.2 to FIG.4 or the method 500 corresponding to FIG.5 to FIG.8, a generated memory cell may be one of the types shown in FIG.1 1 to FIG.14. In a memory cell 1100 of FIG.11, a word line layer WL, an antifuse layer AF1 and another antifuse layer AF2 may be formed on an oxide diffusion layer OD, and the layout may be shown as FIG.1 1. In a memory cell 1200 of FIG.12, a word line layer WL and an antifuse layers AF may be formed on an oxide diffusion layer OD, and the layout may be shown as FIG.12. In a memory cell 1300 of FIG.13, a word line layer WL, a following line layer FL and an antifuse layer AF may be formed on an oxide diffusion layer OD, and the layout may be shown as FIG.13. In a memory cell 1400 of FIG.14, two word line layers WL1 and W12, an antifuse layers AF, and two following line layer FL1 and FL2 may be formed on an oxide diffusion layer OD, and the layout may be shown as FIG.14. In FIG.1 1 to FIG.14, each of the word line layers (e.g., WL, WL1 and WL2), the antifuse layers (e.g. AF, AF1 and AF2) and the following line layers (e.g., FL, FL1 and FL2) may be generated using a polycrystalline material or a polysilicon material. FIG.1 1 to FIG.14 may be merely examples, the types of memory cell generated using a method of an embodiment is not limited to the types of memory cell shown in FIG.11 to FIG.14.

In summary, by means of a method provided by an embodiment, additional Boron implantation operation(s) may be performed to a well region without using additional mask(s), a threshold voltage of an antifuse structure formed on the well region may be increased, and a memory cell with the antifuse structure may have better immunity against erroneous programing caused by a high voltage breaking through a gate layer and a related unwanted leakage current.

**Claims**

1. A semiconductor processing method (200, 500) for manufacturing an antifuse structure **characterised by** comprising:

   using a first mask (M1, M51) for exposing a first well region (W1) of a semiconductor substrate (110);
   performing a first Boron implantation operation (BI1, BI51) to implant Boron into the first well region (W1);
   using a second mask (M2, M52) for exposing the first well region (W1) and the second well region (W2) of the semiconductor substrate (110); and
   performing a second Boron implantation operation (BI2, BI52) to implant Boron into the first well region (W1) and the second well region (W2).

2. The semiconductor processing method (200) of claim 1 **characterised in that** the first well region (W1) is a low voltage well region, and the second well region (W2) is a middle voltage well region.

3. The semiconductor processing method (200) of claim 1 **characterised in that** the first well region (W1) is a low voltage well region, and the second well region (W2) is a high voltage well region.

4. The semiconductor processing method (200) of claim 1 **characterised in that**:

the first Boron implantation operation (BI1) is corresponding to a low voltage p-type well setting; and
the second Boron implantation operation (BI2) is corresponding to a high voltage p-type well setting.

5. The semiconductor processing method (200) of claim 1 **characterised in that**:

the first Boron implantation operation (BI1) is corresponding to a low voltage p-type well setting; and
the second Boron implantation operation (BI2) is corresponding to a high voltage p-type lightly doped drain setting.

6. The semiconductor processing method (200) of claim 1 **characterised in that**:

the first Boron implantation operation (BI1) is corresponding to a low voltage p-type well setting; and
the second Boron implantation operation (BI2) is corresponding to an medium voltage p-type well setting.

7. The semiconductor processing method (200) of claim 1 **characterised by** further comprising:

forming a gate oxide layer (Ox1) on the first well region (W1);
forming a gate layer (G1) on the gate oxide layer (Ox1); and
forming a source region (S1) at a first side of the gate oxide layer (Ox1), and forming a drain region (D1) at a second side of the gate oxide layer (Ox1).

8. The semiconductor processing method (200) of claim 7 **characterised by** further comprising:
forming a lightly dope drain region (LDD) at the first side and the second side of the gate oxide layer (Ox1).

9. The semiconductor processing method (500) of claim 1 **characterised by** further comprising:

using a third mask (M53) for exposing the first well region (W1) and a third well region (W3) of the semiconductor substrate (110); and
performing a third Boron implantation operation (BI53) to implant Boron into the first well region (W1) and the third well region (W3).

10. The semiconductor processing method (500) of claim 9 **characterised in that** the first well region (W1) is a low voltage well region, the second well region (W2) is a middle voltage well region, and the third well region (W3) is a high voltage well region.

11. The semiconductor processing method (500) of claim 9 **characterised in that**:

the first Boron implantation operation (BI51) is corresponding to a low voltage p-type well setting;
the second Boron implantation operation (BI52) is corresponding to a medium voltage p-type well setting; and
the third Boron implantation operation (BI53) is corresponding to a high voltage p-type well setting.

12. The semiconductor processing method (500) of claim 9 **characterised by** further comprising:

forming a gate oxide layer (Ox1) on the first well region (W1);
forming a gate layer (G1) on the gate oxide layer (Ox1); and
forming a source region (S1) at a first side of the gate oxide layer (Ox1), and forming a drain region (D1) at a second side of the gate oxide layer (Ox1).

13. The semiconductor processing method (500) of claim 12 **characterised by** further comprising:
forming a lightly dope drain region (LDD) at the first side and the second side of the gate oxide layer (Ox1).

100

$V_H$

WL          FL          AF

| N⁻ | N⁺ | N⁺ | N⁺ |

<u>W1</u>

110

# FIG. 1

200

| Use a first mask for exposing the first well region of a semiconductor substrate and covering the second well region | ~210 |

| Perform a first Boron implantation operation to implant Boron into the first well region | ~220 |

| Use a second mask for exposing the first well region and the second well region of the semiconductor substrate | ~230 |

| Perform a second Boron implantation operation to implant Boron into the first well region and the second well region | ~240 |

# FIG. 2

M1

BI1

W2    W1

~110

# FIG. 3

M2

BI2

W2    W1

~110

# FIG. 4

500

```
┌─────────────────────────────────┐
│ Use a first mask for exposing the first │
│ well region of the semiconductor │      ~510
│ substrate and covering the second well │
│ region and the third well region of the │
│ semiconductor substrate │
└─────────────────────────────────┘
                 │
                 ▼
┌─────────────────────────────────┐
│ Perform a first Boron implantation │
│ operation to implant Boron into the │     ~520
│ first well region │
└─────────────────────────────────┘
                 │
                 ▼
┌─────────────────────────────────┐
│ Use a second mask for exposing the first │
│ well region and the second well region │    ~530
│ and covering the third well region │
└─────────────────────────────────┘
                 │
                 ▼
┌─────────────────────────────────┐
│ Perform a second Boron implantation │
│ operation to implant Boron into the first │   ~540
│ well region and the second well region │
└─────────────────────────────────┘
                 │
                 ▼
┌─────────────────────────────────┐
│ Use a third mask for exposing the first │
│ well region and a third well region and │    ~550
│ covering the second well region │
└─────────────────────────────────┘
                 │
                 ▼
┌─────────────────────────────────┐
│ Perform a third Boron implantation │
│ operation to implant Boron into the first │   ~560
│ well region and the third well region │
└─────────────────────────────────┘
```

FIG. 5

BI51

M51                                    M51

W3        W2        W1

~110

FIG. 6

BI52

M52                                    M52

W3        W2        W1

~110

FIG. 7

M53  BI53  M53  BI53  M53

W3 W2 W1

110

FIG. 8

900

Ox1  G1

S1  D1

LDD

W1

110

FIG. 9

1000

Form a gate oxide layer
on the first well region ~1010

Form a gate layer on the
gate oxide layer ~1020

Form a lightly dope drain region at a
first side and a second side of the gate
oxide layer ~1030

Form a source region at the first
side of the gate oxide layer, and
form a drain region at the second
side of the gate oxide layer ~1050

FIG. 10

WL  AF1  1100

OD

AF2

FIG. 11

WL  AF  1200

OD

FIG. 12

1300

WL     FL     AF

OD

## FIG. 13

1400

WL1   FL1   AF   FL2   WL2

OD

## FIG. 14

Europäisches
Patentamt

European
Patent Office

Office européen
des brevets

## EUROPEAN SEARCH REPORT

Application Number

EP 19 18 5928

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/214014 A1 (ARIYOSHI RYUJI [JP] ET AL) 20 November 2003 (2003-11-20)<br>* abstract *<br>* paragraphs [0013] - [0020] * | 1-13 | INV.<br>H01L23/525 |
| A | US 6 043 128 A (KAMIYA TAKAYUKI [JP])<br>28 March 2000 (2000-03-28)<br>* abstract *<br>* column 3, lines 26-63 * | 1-13 | |
| A | US 5 242 851 A (CHOI KYU H [US])<br>7 September 1993 (1993-09-07)<br>* abstract *<br>* column 5, lines 3-23 *<br>* figure 3D * | 1-13 | |
| A | US 2009/315109 A1 (KIM MIN-SEOK [KR])<br>24 December 2009 (2009-12-24)<br>* abstract *<br>* paragraphs [0006], [0007] * | 1-13 | |
| A | US 2018/145083 A1 (TONG XIAOGHONG [US] ET AL) 24 May 2018 (2018-05-24)<br>* abstract *<br>* paragraphs [0018] - [0032] * | 1-13 | TECHNICAL FIELDS SEARCHED (IPC)<br><br>H01L |

The present search report has been drawn up for all claims

| Place of search | Date of completion of the search | Examiner |
|---|---|---|
| Munich | 19 August 2019 | Di Felice, M |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 19 18 5928

This annex lists the patent family members relating to the patent documents cited in the above-mentioned European search report.
The members are as contained in the European Patent Office EDP file on
The European Patent Office is in no way liable for these particulars which are merely given for the purpose of information.

19-08-2019

| Patent document cited in search report | | Publication date | Patent family member(s) | | Publication date |
|---|---|---|---|---|---|
| US 2003214014 | A1 | 20-11-2003 | EP<br>US<br>US | 1233453 A2<br>2002117724 A1<br>2003214014 A1 | 21-08-2002<br>29-08-2002<br>20-11-2003 |
| US 6043128 | A | 28-03-2000 | JP<br>JP<br>US | 3304803 B2<br>H10223774 A<br>6043128 A | 22-07-2002<br>21-08-1998<br>28-03-2000 |
| US 5242851 | A | 07-09-1993 | JP<br>KR<br>US | H05136269 A<br>960012302 B1<br>5242851 A | 01-06-1993<br>18-09-1996<br>07-09-1993 |
| US 2009315109 | A1 | 24-12-2009 | CN<br>KR<br>TW<br>US | 101609834 A<br>20090132121 A<br>201001674 A<br>2009315109 A1 | 23-12-2009<br>30-12-2009<br>01-01-2010<br>24-12-2009 |
| US 2018145083 | A1 | 24-05-2018 | CN<br>EP<br>KR<br>TW<br>US<br>WO | 107667426 A<br>3314647 A1<br>20180020285 A<br>201703228 A<br>2018145083 A1<br>2016209242 A1 | 06-02-2018<br>02-05-2018<br>27-02-2018<br>16-01-2017<br>24-05-2018<br>29-12-2016 |

EPO FORM P0459

For more details about this annex : see Official Journal of the European Patent Office, No. 12/82